# EUROPEAN PATENT APPLICATION

(11) **EP 2 975 656 A1**
(43) Date of publication of application: **20.01.2016**
(21) Application number: 14177347.3
(22) Date of filing: 16.07.2014
(51) Int. Cl.: H01L 33/58, F21K 99/00

(54) **An emitting device of wide-angle led**

(71) Applicant: Lumenmax Optoelectronics Co., Ltd., 32063 Zhongli City, Taoyuan County (TW)
(72) Inventor: Yang, Ho-Ching, ZhongLi City, Taoyuan County 32063 (TW); Lin, Chun-Te, ZhongLi City, Taoyuan County 32063 (TW)
(74) Representative: Cabinet Chaillot

(57) **Abstract**

An emitting device of wide-angle LED which comprises at least one wide-angle LED (60) that emits at an angle between 140° and 160°, extending the distance between each wide-angle LED (60) in the emitting device (90) and reducing the number needed for construction. Also, the device has the lights emitted in uniformity and has no dark area. The luminance is improved as well. Besides, the wide-angle LED (60) was applied twice packaging procedures to avoid the sealant body (30) separating from the concavity (14) due to damp environment. The emitting device of wide-angle LED therefore has improved quality and lower prime costs.

## Description

### BACKGROUND OF THE INVENTION

### 1. Field of the Invention:

The present invention relates to an emitting device of wide-angle LED, particularly to one that has a wide-angle LED with wider emitting area and more intensive luminance, so that when engaging an emitting device the number needed for construction is reduced and the quality and effectiveness are improved.

### 2. Description of the Related Art:

Nowadays LED technology is getting advanced and widely applied to emitting devices constructions, and the luminance quality of the devices lies in the optical design of LED structure. Basically the optical design can be divided into primary optics and secondary optics. The structures are as below.
1. Primary optics: within the LED packaging, a colloid in shape of lens covers the LED chip and is fixed on a base, which can adjust the spreading or dispersing of lights; in other words, it functions as a first optical lens and the lights getting through it are in a fixed direction and emitting form. The angle is usually between 110° and 120 °.
2. Secondary optics: in LED application, different devices require different light dispersion and the secondary optics design is for adjustment of the dispersion. The design is basically a second lens for the lights to get through after the primary optical process in order to adjust and/or transform the lights.

However, such optical design neglects the relevance between the primary and secondary optics. Lower relevance has stronger influence on the device. For example, the more intensive the lights are, the narrower the emitting angle is, and the lights are more concentrated. But such concentration would require the distance between each LED arranged less than 1.5cm, resulting more numbers needed for construction; or when the distance is longer than 1.5cm, the lights would not emit uniformly and there would be dark areas. Therefore, it is desirable to focus on relevant designs of LED in order to lower the costs and improve the quality of the device.

### SUMMARY OF THE INVENTION

The primary object of the present invention is to provide an emitting device of wide-angle LED in which the wide-angle LED establishes a crossing and overlapping light dispersion via refraction of primary and secondary optics, in order to extend the distance between each wide-angle LED and thus reduce the number needed to construct the present invention; in other words, to reduce the prime costs.

Another object of the present invention is to provide an emitting device of wide-angle LED in which the wide-angle LED enhances the lights in the primary optical process, concentrating the lights and heightening the intensity, and in the secondary optical process the lights spread out uniformly, so as to improve the quality of the present invention.

In order to achieve the objects above, the present invention comprises a wide-angle LED and an emitting device constructed of the wide-angle LED according to the annexed claims.

With features disclosed above, the present invention has the blue LED chip emits blue lights and refracts through the sealant body as the first optical process, and the blue lights emitted from both sides of the blue LED chip are concentrated by the heat dissipating sink and the intensity thereof is heightened. Then the concentrated blue lights refract through the lens and turn into blue rays as the secondary optical process, uniformly emitting out. The crossing and overlapping blue rays enable the extension of the distance between each wide-angle LED in the emitting device, and thus reduce the number needed for construction; together with the heightened intensity of blue rays, the present invention has features as lower prime costs and better quality.

### BRIEF DESCRIPTION OF THE DRAWINGS

FIG. 1 is a perspective view of the wide-angle LED of the present invention;
FIG. 2 is a sectional view along line 2-2 in FIG. 1;
FIG. 3 is a sectional view along line 3-3 in FIG. 2;
FIG. 4 is a schematic diagram illustrating blue rays dispersion of the wide-angle LED of the present invention viewing from its length;
FIG. 5 is a schematic diagram illustrating blue rays dispersion of the wide-angle LED of the present invention viewing from its width;
FIG. 6 is an exploded view of the emitting device of the present invention;
FIG. 7 is a sectional view of the emitting device of the present invention;
FIG. 8 is a sectional view along line 8-8 in FIG. 7.

### DETAILED DESCRIPTION OF THE PREFERRED EMBODIMENT

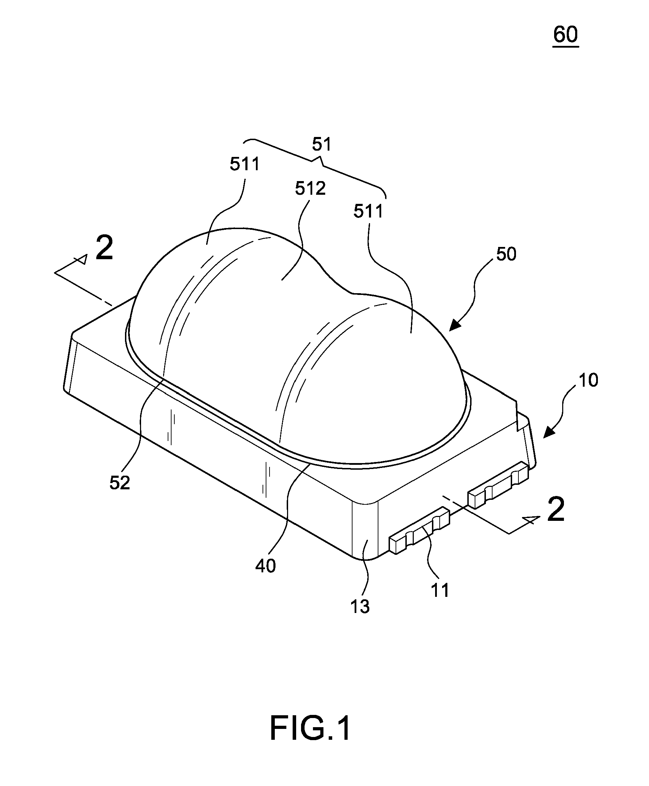

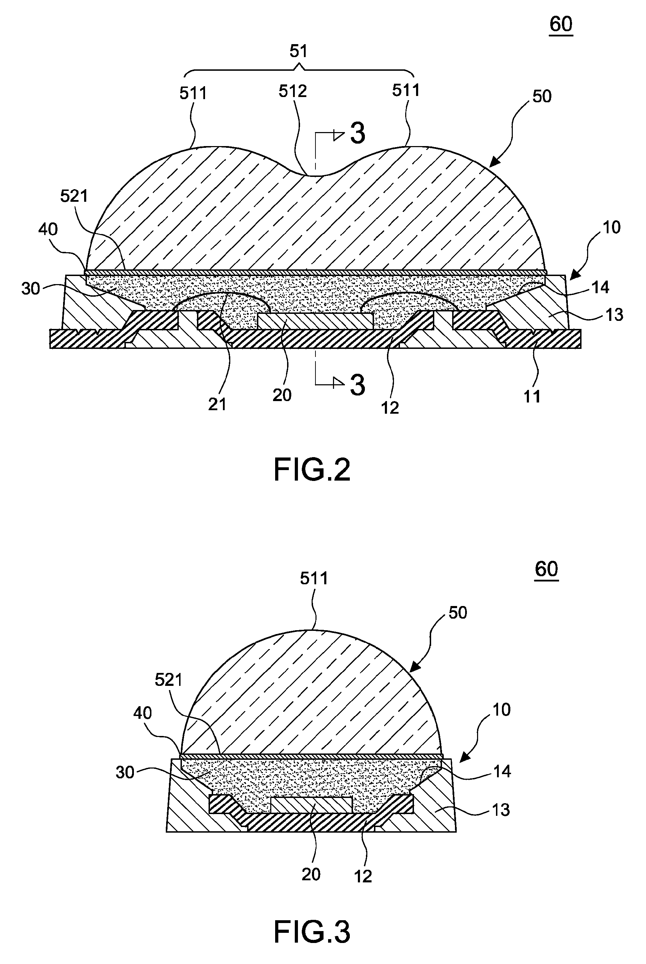

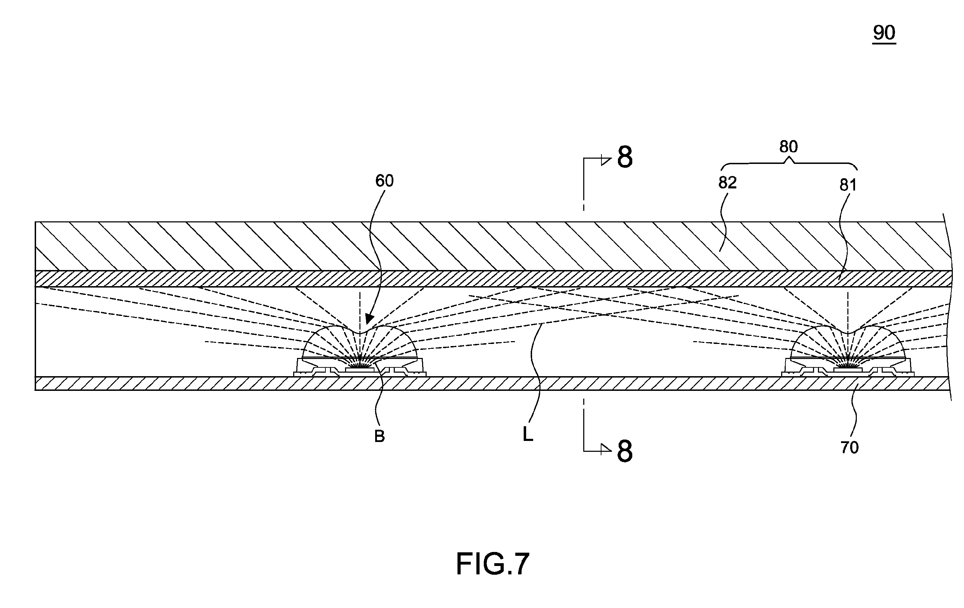

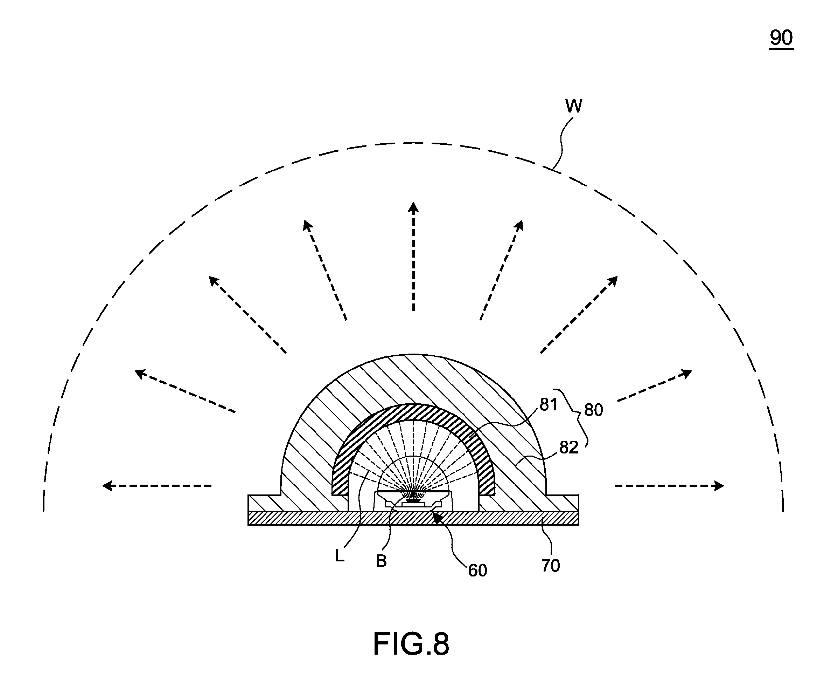

Referring to FIGS. 1-8, a preferred embodiment of the present invention comprises a wide-angle LED **60** including a base **10,** a blue LED chip **20,** a sealant body **30,** and a lens **50,** and an emitting device **90** including a least one wide-angle LED **60,** a PCB **70,** and a lighting tube **80.**

The base **10** is formed by a pair of metal connecting base **11,** a heat dissipating sink **12** and a rectangular housing **13.** The metal connecting base pair **11** are arranged separately at the front and rear of the heat dissipating sink **12** and fixed together with it by the lower part of said rectangular housing **13;** the upper thereof surrounds the heat dissipating sink **12** and forms a long concavity **14,** keeping the underside of the metal connecting base **11** and the heat dissipating sink **12** exposed, and the top of the metal connecting base pair **11** partially exposed.

The blue LED chip **20** is arranged on the heat dissipating sink **12** and the electrodes thereof are connected separately to the metal connecting base **11** by conductive wires **21.** In this embodiment, the heat dissipating sink **12** is step-like and reflective with the blue LED chip **20** arranged on it, so that it can reflect and concentrate the lights emitted from both sides of the blue LED chip **20,** heightening the light intensity. Moreover, the heat dissipating sink **12** inclines towards the bottom at an angle between 40° and 50 °.

The sealant body **30** is filling said concavity **14** to encapsulate the blue LED chip **20** and conductive wires **21** as the first packaging procedure. In this embodiment, the refraction index of the sealant body **30** is greater than 1.5; the sealant body **30** has the binding material **40** spreading, and it can be made of silica gel.

The lens **50** is in oblong shape and adhered by the binding material **40** as the second packaging procedure. The length is defined as the lateral side. In a lateral view the top surface **51** thereof has a first surface area **511** on two symmetrical bulges and a second surface area **512** on the sinking area in the middle, and the bottom **52** thereof has a third surface area **521;** the bulging curvature of said first surface area **511** has a pre-determined point on the third surface area **521** as the center, and the radius of curvature can be 1.2mm to 1.4mm so that the blue rays (**L**) would be emitted through the first surface area **511** at an angle between 140 ° to 160 °. In addition, the refractive index of said lens **50** is greater than 1.4, less than the one of the sealant body 30; and the blue LED chip **20** is located right underneath the second surface area **512.**

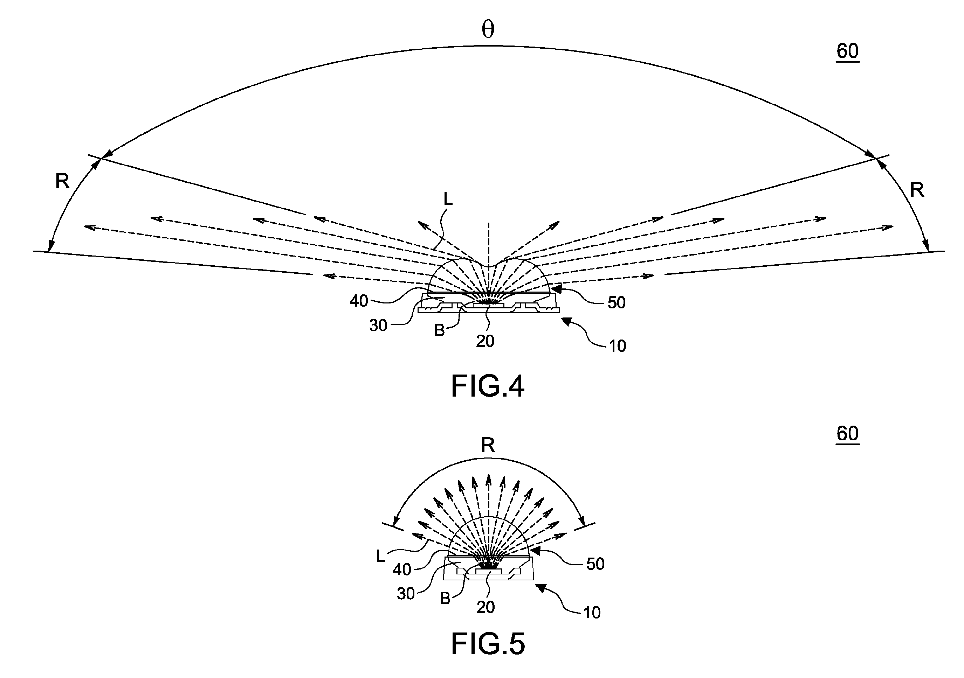

FIGS. 4 and 5 disclose the dispersion of blue rays viewing from its length and width. The blue lights **(B)** from the blue LED chip **20** go through the sealant body **30** and deflect through the third surface area **521,** turning into blue rays **(L)** and reaching the estimated emitting area **(R)** of the first surface area **511,** then emitting at a wide angle.

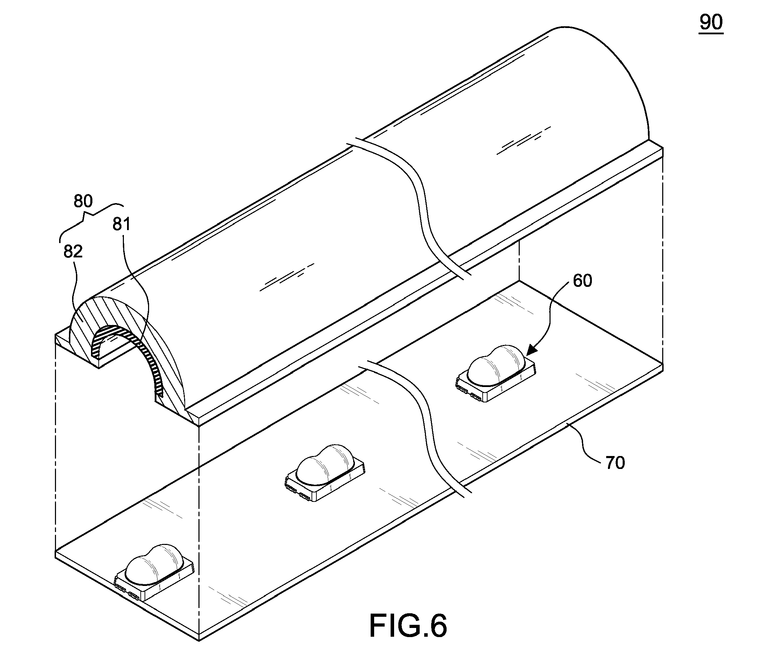

Referring to FIGS. 6-8, the emitting device **90** constructed of the wide-angle LED **60** comprises at least one wide-angle LED **60** disclosed above, a PCB 70 electrically connected to each wide-angle LED **60** that has a distance of at least 1.5cm between each other, and a lighting tube **80** shaped in semi-cylindrical and constructed of a thinner yellow fluorescent layer **81** inside and a thicker color mixing layer **82** outside, covering said wide-angle LED **60** on said PCB **70;** whereby the wide-angle LED **60** emits crossing and overlapping blue rays **(L)** when the PCB **70** is connected, and the blue rays **(L)** pass through the yellow fluorescent layer **81** and turn into white lights **(W)** in the color mixing layer **82.** In this embodiment, the wide-angle LED **60** emits blue lights **(B)** that activate the yttrium aluminium garnet (YAG) yellow fluorescent powder and turn into white lights **(W)** but the present invention is not limited to such application.

With aforesaid structures and measures, the wide-angle LED **60** of the present invention widens the emitting angle and thus raises 15% of luminance by the secondary optics effect in which the blue lights **(B)** emitted from the blue LED chip **20** are concentrated upwards by the step-like heat dissipating sink **12** and the blue rays **(L)** are therefore intensified, and then emit in white lights **(W)** uniformly after going through the yellow fluorescent layer **81** and mixing in the color mixing layer **82.** On the other hand, the wide-angle LED **60** was applied twice packaging procedures to avoid the sealant body **30** separating from the concavity **14,** prolonging the durability of the present invention.

Although a particular embodiment of the invention has been described in detail for purposes of illustration, various modifications and enhancements may be made without departing from the spirit and scope of the invention. Accordingly, the invention is not to be limited except as by the appended claims.

## Claims

1. An wide-angle LED (60), comprising:
a base (10) formed by a pair of metal connecting base (11), a heat dissipating sink (12) and a rectangular housing (13); said metal connecting base pair (11) being arranged separately at the front and rear of the heat dissipating sink (12) and fixed together with it by the lower part of said rectangular housing (13); the upper thereof surrounding the heat dissipating sink (12) and forming a long concavity (14), keeping the underside of said metal connecting base (11) and said heat dissipating sink (12) exposed, and the top of said metal connecting base pair (11) partially exposed;
a blue LED chip (20) arranged on said heat dissipating sink (12) and the electrodes thereof connected separately to the metal connecting base (11) by conductive wires (21);
a sealant body (30) filling said concavity (14) to encapsulate said blue LED chip (20) and conductive wires (21);
a binding material (40) spreading on said sealant body (30); and
a lens (50) in oblong shape and adhered by said binding material (40), in a lateral view the top surface (51) thereof has a first surface area (511) on two symmetrical bulges and a second surface area (512) on the sinking area in the middle, and the bottom (52) thereof has a third surface area (521); the refractive index of said lens (50) being less than the one of said sealant body (30); and said blue LED chip (20) being located right underneath the second surface area (512);
whereby the blue light (B) from said blue LED chip (20) goes through said sealant body (30) and deflects through the third surface area (521), turning into blue rays (L) and reaching the estimated emitting area (R) of the first surface area (511), then emitting at a wide angle.

2. The wide-angle LED (60) as claimed in claim 1, wherein said heat dissipating sink (12) is step-like with the blue LED chip (20) arranged on so that it can reflect and concentrate the lights emitted from both sides of the blue LED chip (20).

3. The wide-angle LED (60) as claimed in claim 2, wherein both sides of said heat dissipating sink (12) inclines towards the bottom at an angle between 40 ° and 50 ° .

4. The wide-angle LED (60) as claimed in claim 1, wherein the refraction index of the sealant body (30) is greater than 1.5, and the one of the lens (50) is greater than 1.4.

5. The wide-angle LED (60) as claimed in claim 1, wherein the bulging curvature of said first surface area (511) has a pre-determined point on the third surface area (521) as the center, and the radius of curvature can be 1.2mm to 1.4mm so that the blue rays (L) would be emitted through the first surface area (511) at an angle between 140 ° to 160 °.

6. An emitting device (90) constructed of the wide-angle LED (60) as claimed in claim 1, comprising:
at least one wide-angle LED (60);
a PCB (70) electrically connected to each wide-angle LED (60) that has a distance of at least 1.5cm between each other; and
a lighting tube (80) shaped in semi-cylindrical and constructed of a thinner yellow fluorescent layer (81) inside and a thicker color mixing layer (82) outside, covering said wide-angle LED (60) on said PCB (70);
whereby the wide-angle LED (60) emits crossing and overlapping blue rays (L) when the PCB (70) is connected; and the blue rays (L) pass through the yellow fluorescent layer (81) and turn into white light (W) in the color mixing layer (82).

7. The emitting device (90) as claimed in claim 6, wherein the heat dissipating sink (12) is step-like with the blue LED chip (20) arranged on so that it can reflect and concentrate the lights emitted from both sides of the blue LED chip (20).

8. The emitting device (90) as claimed in claim 7, wherein both sides of said heat dissipating sink (12) incline towards the bottom at an angle between 40 ° and 50 ° .

9. The emitting device (90) as claimed in claim 6, wherein the refraction index of the sealant body (30) is greater than 1.5, and the one of the lens (50) is greater than 1.4.

10. The emitting device (90) as claimed in claim 6, wherein the bulging curvature of said first surface area (511) has a pre-determined point on the third surface area (521) as the center, and the radius of curvature can be 1.2mm to 1.4mm so that the blue rays (L) would be emitted through the first surface area (511) at an angle between 140 ° to 160 °.
